# EUROPEAN PATENT SPECIFICATION

(11) **EP 4 364 179 B1**
(45) Date of publication and mention of the grant of the patent: **04.12.2024**
(21) Application number: 22751265.4
(22) Date of filing: 29.06.2022
(51) Int. Cl.: H01J 37/04, H01J 37/244, H01J 37/26

(54) **A MULTI-MODE LOW-VOLTAGE ELECTRON MICROSCOPE**
MULTIMODALES NIEDERSPANNUNGS-ELEKTRONENMIKROSKOP
MICROSCOPE ÉLECTRONIQUE BASSE TENSION MULTIMODE

(43) Date of publication of application: 08.05.2024
(73) Proprietor: Delong Instruments A.S., 61200 Brno (CZ)
(72) Inventor: BEJDÁK, Tomás, 67922 Svinosice (CZ); COUFALOVÁ, Eva, 60200 Brno (CZ); STEPAN, Petr, 61500 Brno (CZ)
(74) Representative: Kendereski, Dusan
(86) International application number: PCT/CZ2022/050061
(87) International publication number: WO 2024/002399

(56) References cited:
- US-A1- 2014 077 080
- "Biological Field Emission Scanning Electron Microscopy", 6 February 2019, WILEY, ISBN: 978-1-118-66326-4, article MICHAEL F HAYLES: "Akashi Seisakusho Ltd - SEM Development 1972-1986", pages: 7 - 23, XP055643273, DOI: 10.1002/9781118663233.ch2

## Description

### [Technical Field

The present invention relates to a multi-mode low-voltage electron microscope enabling EDS analysis and at least one of STEM, TEM, ED and SEM analysis of a sample. The present disclosure further relates to a non-claimed arrangement of an electron microscope and an EDS detector for detecting a signal of energy-dispersed X-ray radiation in the electron microscope.

### Background Art

For the purposes of this disclosure, the following abbreviations are explained herein: SEM (scanning electron microscope), STEM (scanning transmission electron microscope), TEM (transmission electron microscope), ED (electron diffraction), EDS being equivalent with EDX (energy-dispersive X-ray spectroscopy), sCMOS (scientific complementary metal-oxide-semiconductor), AES (atomic emission spectroscopy), EELS (electron energy loss spectroscopy), BSE (back-scattered electrons), EM (electromagnetic), ES (electrostatic), MS (magnetostatic).

Conventional TEM design is connected with increased demands for space and conditions, high energy consumption and consumption of supporting media, mainly cooling water. Its installation is complicated and often requires construction work. Electromagnetic components, such as electromagnetic coils, often used together with polepieces, are conventionally used in transmission electron microscopes for focusing and magnifying, which requires a space-demanding external cooling system. Therefore, their operation is limited to special laboratories and means a significant ecological load.

It has been known that lower electron energy (e. g. below 30 kV) in low-voltage electron microscopes avoids in many cases sample damage, increases robustness of a microscope, allows for miniaturisation of the whole device and lowers its sensitivity to vibrations. Equally, magnetostatic and electrostatic optics in electron microscopes does not create any heat loss, thus avoiding cooling and allowing further miniaturisation as opposed to conventionally used electromagnetic optics. However, a further trend in miniaturisation is hindered by other design aspects, such as arranging detectors and optics together in positions necessary for good detection efficiency.

Moreover, electron microscopy has seen another trend in providing electron microscope capable of multiple analytic modes at the same time or at least within the same microscope to exploit potential analytical outcomes of a given sample while reducing time and equipment required for such an analysis.

What is more, insulating the optics from the accompanying electronics of the microscope and its negative impact on the analysis has also caused problems in miniaturisation of electron microscopes.

A multi-mode low-voltage electron microscope operative in the accelerating voltage range of 10 to 25 kV and enabling STEM, TEM and ED sample analysis is known as LVEM25 (by DELONG, see e.g. https://delongamerica.com/lvem25). The accelerating voltage of 25 kV is used for TEM analysis and the accelerating voltage of 10 to 15 kV is used for STEM analysis, thus securing sufficient beam penetration of a sample, better imaging properties, higher contrast and the possibility to analyse both stained and non-stained samples. It comprises a magnetostatic condenser lens, a magnetostatic objective lens and an electrostatic projective lens, which removes the need to cool down these lenses and results in a compact microscope. Each magnetostatic lens, i. e. the magnetostatic condenser lens and the magnetostatic objective lens, comprises at least one permanent magnet and at least one polepiece in order to create a field of magnetostatic lens. Each electrostatic lens, i. e. the electrostatic projective lens, comprises at least one shaped electrode connected to supply voltage or ground potential in order to create a field of electrostatic lens. An electron beam source is a 25 kV Schottky-type field emission gun providing high brightness and spatial coherence with high contrast. A sample stage can be moved in a precise way by means of joystick-controlled piezoelectric actuators. A combination of a diaphragm pump and a turbomolecular pump assures long maintenance-free operation and an ion getter pump provides vibration-free environment. The TEM mode uses an sCMOS camera as a detector. A disadvantage of the LVEM25 microscope is the absence or further detection modes.

A similar multi-mode low-voltage electron microscope operative in the accelerating voltage of 5 kV and enabling SEM, STEM, TEM and ED sample analysis is known as LVEM5 (by DELONG). The LVEM5 microscope differs from the above-mentioned LVEM25 microscope in the electron beam source being a 5 kV Schottky-type field emission gun, providing accelerating voltage of 5 kV for SEM, STEM and TEM analysis. The TEM mode uses an sCMOS camera as a detector and the SEM mode uses a detector for back-scattered electrons. A disadvantage of the LVEM5 microscope is the absence or further detection modes.

Another multi-mode electron microscope is disclosed in JP 2722889 B2, enabling SEM, STEM, EDX, AES, EELS, Auger spectroscopy analysis and quantitative/qualitative elemental analysis modes. It is operative in accelerating voltage below 40 kV (e. g. 30 kV or 5 kV) in the SEM and STEM modes, securing high contrast and electron beam stability and avoiding charge accumulation and sample damage. This document also discloses a transmission electron microscope used in comparative examples. A disadvantage of the microscope disclosed in JP 2722889 B2 is the absence or further detection modes. Furthermore, the embodiment of EDX detection is not sufficiently disclosed in terms of structural features.

EDX detectors, including a collimator, are conventionally mounted onto a microscope chamber, which requires a great deal of precision in order to direct the collimator such that it detects as much desired signal originating from the sample as possible and at the same time, as little parasitic signal not originating from the sample as possible. The aspect of precision gains importance in trends in miniaturisation of microscope chambers or if another detector, such as an SEM detector, is present in the vicinity.

Further related multi-mode electron microscopes are disclosed in US 6573502 B2 (SEM, STEM and TEM modes, accelerating voltage not mentioned) and US 6875984 B2 (SEM, STEM and TEM modes, accelerating voltage being 100 to 120 k and it can be lowered as low as 50 kV).

An arrangement of an electron microscope and an EDS detector for detecting a signal of energy-dispersed X-ray radiation in an electron microscope is disclosed in US 2014077080 A1. Based on Fig. 3 and par. 0020 and 0027 of said US patent application, the electron microscope comprises an objective polepiece and an EDS detector comprising a support ring (being a part of a collimator) attached to the objective polepiece.

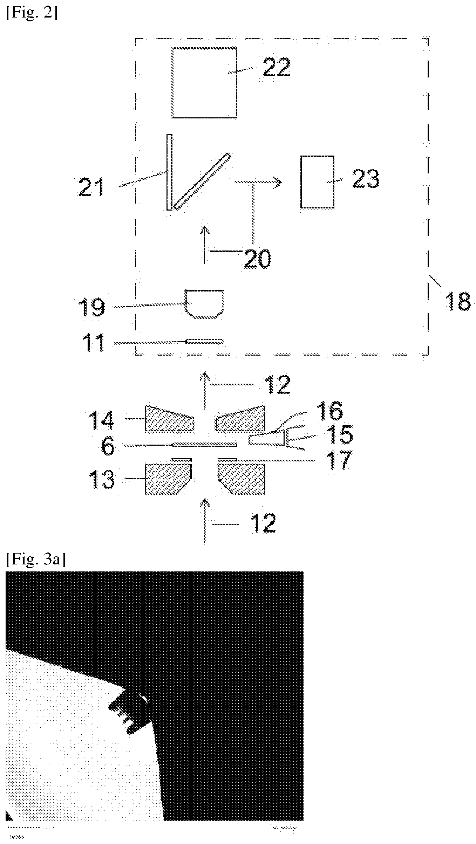

The publication of Hayles et al., 2019, titled "Akashi Seisakusho Ltd - SEM Development 1972-1986" discloses on pages 10, 11, 13 and Fig. 2.3 a SEM having an EDX detector which is arranged between objective lens polepieces essentially co-planarly and laterally with respect to a sample holder and which does not comprise a collimator.

As seen from above, known multi-mode electron microscope operative in accelerating voltage range of less than 50 kV allow for an analysis of a sample only in certain modes, being either STEM, TEM and ED modes, or SEM, STEM and EDX modes. Based on the prior art, there is a need to provide a multi-mode electron microscope operative in accelerating voltage range of less than 50 kV that would combine more analysis modes and that would provide an analysis of a sample in these modes essentially (almost or actually) simultaneously.

### Summary of Invention

It is therefore an object of this invention to provide a multi-mode electron microscope operative in accelerating voltage range of 3-50 kV, which combines an EDS mode with at least one of STEM, TEM, ED and optionally, SEM modes.

According to the invention, the above-mentioned object is achieved by a multi-mode low-voltage electron microscope according to independent claim 1 and dependent claims 2 to 13. The electron microscope is operative in the accelerating voltage range of 3-50 kV, such as at 5 kV, 10 kV, 15 kV, 20 kV, 25 kV or 30 kV, and comprises in the following order based on the direction of a primary electron beam: an electron beam source to generate the primary electron beam, a first magnetostatic condenser lens means, a second magnetostatic condenser lens means, a condenser aperture, a sample holder, a magnetostatic objective lens means, an objective aperture, a first electrostatic projective lens means, and an end detection system. The second magnetostatic condenser lens means and the magnetostatic objective lens means together comprise a first objective polepiece and a second objective polepiece with a sample holder arranged between the respective first and second objective polepieces.

The end detection system comprises a detection screen (commonly denoted as fluorescent screen in TEM applications or scintillator screen in SEM applications) and at least one detector selected from a STEM detector configured to detect a signal of transmitted electrons, a TEM detector configured to detect a signal of transmitted electrons and/or an ED detector configured to detect a signal of diffracted electrons.

The underlying idea of this invention is that an EDS detector configured to detect a signal of energy-dispersed X-ray radiation (EDS signal) is arranged between the first objective polepiece and the second objective polepiece, essentially co-planarly and laterally with respect to the sample holder. The EDS detector comprises a collimator attached to the second objective polepiece. Under "attached" a mechanical attachment is herein understood. The advantage of mounting the collimator to the second objective polepiece instead of mounting it to the EDS detector further mounted to a microscope chamber is an easier, more flexible, yet more precise way of providing all the necessary structural elements for EDS detection. Importantly, such an advantage allows miniaturisation of the whole immersion objective, and by extension of the whole electron microscope. The EDS detector having the collimator according to the invention is robust enough to provide a sufficiently noise-free EDS signal originating from the sample in a miniaturised immersion objective assembly.

In general, collimators are commonly attached to EDS detectors mounted on the microscope chamber and serve to limit the incidence of EDS signals, which do not originate directly from a sample, on the detector. A collimator is usually tubular in shape, i. e. an enclosure with at least two (and usually two) open ends, and is usually made of a single element material, whose spectral lines can be easily subtracted in the analysis, such as zirconium, gold or pure graphite.

The first and second magnetostatic condenser lens means serve to alter the properties of a light signal in the end detection system and, as it is generally known from prior art, each magnetostatic condenser lens means comprises at least one permanent magnet and at least one polepiece in order to create a field of magnetostatic condenser lenses. Similarly, and as it is known from prior art, the magnetostatic objective lens means comprises at least one permanent magnet and at least one polepiece in order to create a field of magnetostatic objective lens. The first and second objective polepieces together with an assembly of permanent magnets create a strong magnetic field in an immersion objective. The magnetic field of the immersion objective has two parts, where the part ahead of the sample functions as the second magnetostatic condenser lens and the part behind the sample as the magnetostatic objective lens. The condenser aperture can be embodied as a condenser multi-aperture sheet including a plurality of condenser apertures of different diameters. Similarly, the objective aperture can be embodied as an objective multi-aperture sheet including a plurality of objective apertures of different diameters. The first electrostatic projective lens means serves to magnify the image and its projection on the detection screen and, as it is generally known from prior art, the first electrostatic projective lens means comprises at least one shaped electrode connected to supply voltage or ground potential in order to create a field of electrostatic projective lens.

As an example, the accelerating voltage can be 25 kV for TEM mode, 10 or 15 kV for STEM/SEM modes, 10, 15 or 25 kV for EDS mode. Different detection modes are achieved by different processing and parameters of the primary electron beam.

Preferably, the multi-mode low-voltage electron microscope comprises a SEM detector configured to detect a signal of back-scattered electrons (BSE) and arranged between the first objective polepiece and the sample holder.

Preferably, the TEM detector and the ED detector are constructed as a combined TEM/ED detector comprising a camera, wherein in order to change between these modes, the rear focal plane, in which the diffraction signals are detected, needs to be re-focused by means of the electrostatic projective leans means. Preferably, the STEM detector comprises a photomultiplier tube.

Preferably, the STEM detector and/or the TEM detector is/are configured to detect transmitted electrons in a bright field detection mode and in a dark field detection mode. For TEM mode, the bright and dark field detection modes are switched by beam inclination and subsequent selection of a suitable diffracted beam. For STEM mode, the bright and dark field detection modes are switched by changing the position of a detector aperture.

Preferably, the multi-mode low-voltage electron microscope comprises a tilting mirror arranged in the end detection system between the detection screen and the STEM, TEM and ED detectors such that the tilting mirror allows a light signal generated by the detection screen to pass to the TEM and/or ED detector in a first position and to the STEM detector in a second position. As a result, it is no longer needed to move the detectors in a demanding manner when changing modes.

Preferably, the sample holder is vertically adjustable.

Preferably, the multi-mode low-voltage electron microscope comprises an electrostatic condenser lens means arranged between the electron beam source and the first magnetostatic condenser lens means. The electrostatic condenser lens means is adjustable and, as it is generally known from prior art, the electrostatic condenser lens means comprises at least one shaped electrode connected to supply voltage or ground potential in order to create a field of electrostatic condenser lens.

Preferably, the multi-mode low-voltage electron microscope comprises a second electrostatic projective lens means arranged between the first electrostatic projective lens means and the end detection system. The second electrostatic projective lens means allows to increase the extent of magnification and, as it is generally known from prior art, the second electrostatic projective lens means comprises at least one shaped electrode connected to supply voltage or ground potential in order to create a field of electrostatic projective lens.

Preferably, the end detection system comprises a light objective arranged between the detection screen and at least one detector, or when the tilting mirror is present, between the detection screen and the tilting mirror. The light objective assures a decrease in sensitivity to undesired vibrations and electromagnetic interference with accompanying electronics. The light objective further assures that the signal of transmitted electrons reaches the STEM and/or TEM detectors.

Preferably, the multi-mode low-voltage electron microscope comprises integrated control electronics and high voltage supply and a cooling means, such as a fan or a plurality of fans. The remaining part of the electron microscope (i. e. the column with the features specified in previous paragraphs) is electromagnetically shielded from the control electronics and high voltage supply and the cooling means by means of magnetic shielding and/or thermally shielded from the control electronics and high voltage supply and the cooling means by means of thermal shielding and/or vibrationally shielded from the control electronics and high voltage supply and the cooling means by means of a cooling means damper and/or a column damper and/or a camera damper. The microscope is preferably at least partially shielded by means of an X-ray shield, inter alia comprising the camera damper. In particular the microscope column, including the EDS detector, is shielded by the X-ray shield in order to protect the operator from X-ray radiation.

In addition, zone power control of the control electronics and high voltage supply and the cooling means can be provided in order to prevent heat transfer therefrom to the remaining part of the electron microscope (i. e. the column). A system of thermal shielding and zone heat control conducting the heat from the electronics enables to connect the column and the electronics into a single structure, thus saving more space.

Preferably, the multi-mode low-voltage electron microscope comprises an ion pump configured to create vacuum and integrally coupled with at least one recovery baking element connected to a baking unit for automatized vacuum recovery (e. g. after transport or vacuum break). The baking unit controls and powers heating of the ion pump by means of at least one recovery baking element arranged integrally with the ion pump, which can easily put the microscope into operation in several hours. The heating of the ion pump causes the release of adsorbed molecules (usually water from air moisture) from the respective inner surfaces, which is then followed by evacuating these molecules by the ion pump. Since only a part of the microscope is heated, the baking unit refers to a soft baking function. Because the recovery baking elements arranged integrally with the ion pump operate on low, secure voltage with precisely defined power, no temperature sensor regulation is necessary, and the system is simple and robust.

In the second, non-claimed aspect which does not from part of the invention, the above-mentioned object is achieved by an arrangement of an electron microscope and an EDS detector for detecting a signal of energy-dispersed X-ray radiation in the electron microscope. The electron microscope of that non-claimed generally comprises an objective polepiece and the EDS detector comprises a collimator attached to the objective polepiece. The advantages of such mounting are mentioned above and apply also in other electron microscopes aiming to provide EDS detection mode and comprising a general objective polepiece. As an example, the collimator can be attached to an objective polepiece behind a sample holder based on the direction of a primary electron beam, such as in the multi-mode low-voltage electron microscope according to the invention. As another example, the collimator can be attached to an objective polepiece ahead of a sample holder based on the direction of a primary electron beam, such as in scanning electron microscopes generally having the sample holder arranged behind the objective polepiece(s).

### Brief Description of Drawings

[Fig.1] shows an optics diagram of a prior art TEM (1A) in comparison with a multi-mode low-voltage electron microscope according to the present invention (1B) or equally according to a prior art LVEM25 microscope (1B);
[Fig. 2] shows a detailed arrangement of various detectors of the multi-mode low-voltage electron microscope according to the present invention;

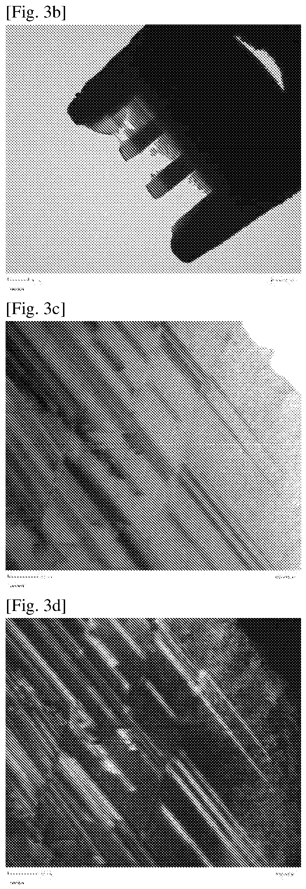

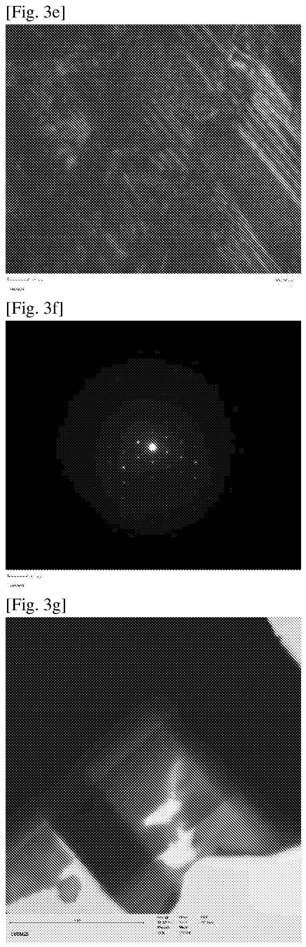

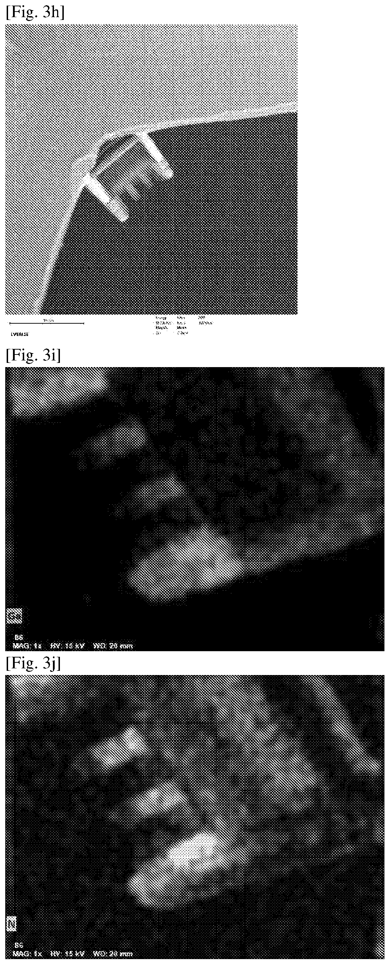

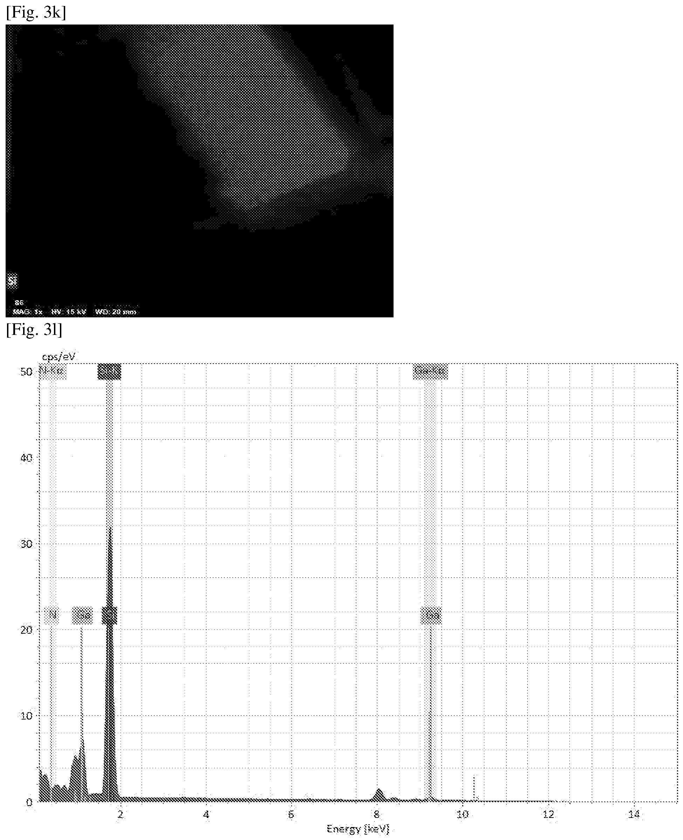

[Fig. 3a] to [Fig. 3l] show electron microscope images of a gallium nitride lamella taken from the same sample in one frame, wherein [Fig. 3a] shows a sample overview in TEM mode at low magnification, [Fig. 3b] shows identification of points of interest in TEM mode at low magnification, [Fig. 3c] shows sample analysis in TEM bright field mode, [Fig. 3d] shows sample analysis in TEM dark field mode at one diffraction maximum, [Fig. 3e] shows sample analysis in TEM dark field mode at another diffraction maximum, [Fig. 3f] shows electron diffraction (ED) corresponding with TEM dark field mode, [Fig. 3g] shows sample analysis in STEM mode, [Fig. 3h] shows sample analysis in SEM (BSE) mode, [Fig. 3i] shows gallium mapping in the sample by EDS, [Fig. 3j] shows nitrogen mapping in the sample by EDS, [Fig. 3k] shows silicon mapping in the sample by EDS, and [Fig. 3l] shows a graphical representation of elemental sample analysis by EDS;
[Fig. 4] shows features of integrated design of the multi-mode low-voltage electron microscope according to the present invention;
[Fig. 5] schematically shows an example of the electron microscope according to the invention.

### Examples

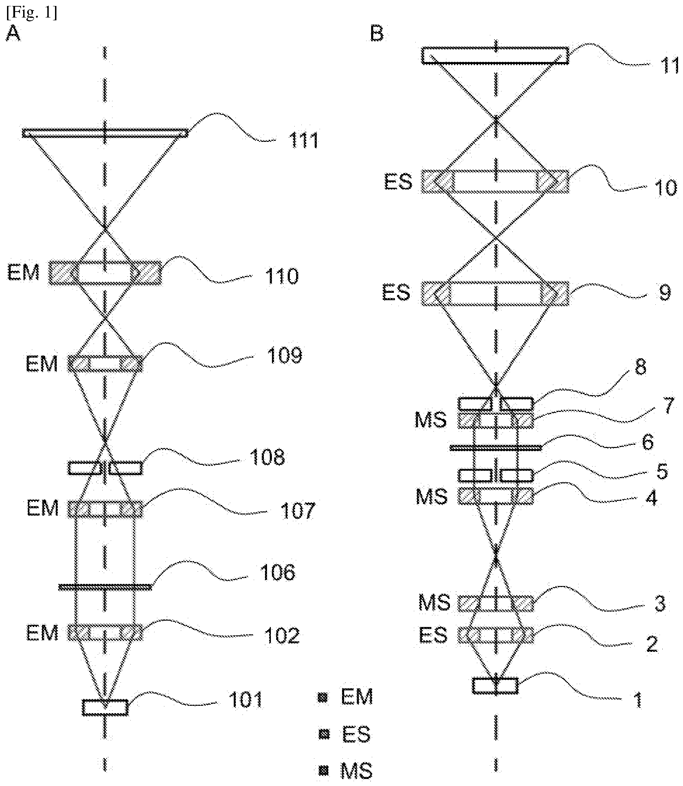

An optics diagram of a conventional transmission electron microscope is shown in Fig. 1A. For the purposes of clarity, the diagram is shown upside down compared to a real microscope. The TEM comprises in the following order based on the direction of a primary electron beam (bottom to top): an electron beam source 101 to generate the primary electron beam, an electromagnetic condenser lens means 102, a sample holder 106 for holding a sample, an electromagnetic objective lens means 107, an objective aperture 108, an assembly of intermediate lens means 109, an electromagnetic projective lens means 110 and a detection screen 111. Each electromagnetic element produces undesirable heat and requires cooling, which is often spatially demanding.

An optics diagram of the electron microscope according to the present invention as well as the prior art electron microscope titled LVEM25 (by DELONG) is shown in Fig. 1B. The electron microscope comprises in the following order based on the direction of a primary electron beam 12 (bottom to top, the beam 12 is also shown in Fig. 2): an electron beam source 1 to generate the primary electron beam 12, an electrostatic condenser lens means 2, a first magnetostatic condenser lens means 3, a second magnetostatic condenser lens means 4, a condenser aperture 5, a sample holder 6 for holding a sample, a magnetostatic objective lens means 7, an objective aperture 8, a first electrostatic projective lens means 9, a second electrostatic projective lens means 10 and a detection screen 11. The electrostatic and magnetostatic elements do not produce undesirable heat, therefore do not need to be cooled, which can advantageously lead to miniaturisation of the microscope.

A detailed arrangement of various detectors of the electron microscope according to the present invention is shown in Fig. 2. The second magnetostatic condenser lens means 4 and the magnetostatic objective lens means 7 together comprise a first objective polepiece 13 (bottom) and a second objective polepiece 14 (top). The sample holder 6 is arranged between the objective polepieces 13, 14, which together with an assembly of permanent magnets create a strong, two-part magnetic field in an immersion objective. The part ahead of the sample holder 6 acts as the second magnetostatic condenser lens and the part behind the sample holder 6 as the magnetostatic objective lens.

An EDS detector 15 configured to detect a signal of energy-dispersed X-ray radiation is arranged between the first objective polepiece 13 and the second objective polepiece 14. The EDS detector 15 is arranged essentially co-planarly and laterally with respect to the sample holder 6 (i. e. on the side of the sample holder 6). The EDS detector 15, itself attached to a microscope chamber, comprises a tubular collimator 16 attached to the second objective polepiece 14. Moreover, a SEM detector 17 configured to detect a signal of back-scattered electrons is arranged between the first objective polepiece 13 and the sample holder 6.

The detection screen 11 for generating a light signal 20 is comprised in an end detection system 18 together with a light objective 19, a tilting mirror 21, a STEM detector 23 comprising a photomultiplier tube and configured to detect a signal of transmitted electrons and a combined TEM/ED detector 22 comprising a camera (such as of sCMOS type) and configured to detect a signal of transmitted and diffracted electrons. The tilting mirror 21 is arranged between the light objective 19 and the STEM, TEM and ED detectors 22, 23 such that it allows a light signal 20 generated by the detection screen 11 and modified by the light objective 19 to pass to the TEM/ED detector 22 in a first position and to the STEM detector 23 in a second position.

Results from an analysis of a gallium nitride lamella sample are shown in Fig. 3a-3k. Fig. 3a and 3b show a sample overview and detailed sample overview in TEM mode under low magnification at 25 kV. Fig. 3c shows a sample part in TEM bright field mode at 25 kV. Fig. 3d and 3e show a sample part in TEM dark field mode at 25 kV at two different diffraction maxima. Fig. 3f shows an electron diffraction pattern of the sample at 25 kV, corresponding with TEM dark field mode in Fig. 3d and 3e. Fig. 3g shows a sample part in STEM bright field mode at 15 kV. Fig. 3h shows a sample part in SEM mode at 15 kV. Fig. 3i, 3j and 3k show a sample part in EDS mode at 15 kV with atom mapping (Fig. 3i for gallium, Fig. 3j for nitrogen, Fig. 3k for silicon). Fig. 3l shows a graphical representation of elemental sample analysis in EDS mode at 15 kV, showing characteristic Kα transitions (peaks from left to right: a typical peak region for nitrogen at approximately 0.4 keV, a dominant peak for gallium at approx. 1.1 keV, a dominant peak for silicon at approx. 1.7 keV, a dominant peak for gallium at approx. 9.2 keV).

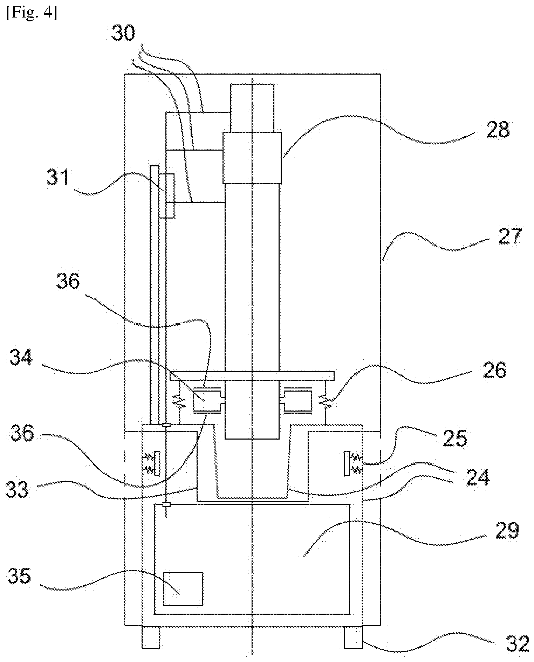

An overall view of the electron microscope, including the features of integrated design are shown in Fig. 4. The bottom part of the microscope comprises control electronics and high voltage supply 29, which produces heat and needs to be cooled with a cooling means, such as fans, arranged on cooling means dampers 25. The microscope column arranged in the middle must be electromagnetically, thermally and vibrationally shielded from the control electronics and high voltage supply 29 by means of magnetic shielding 24, thermal shielding 33 and column dampers 26. The camera arranged in the top and connected via cables 30 secured with cable clamping 31 to the control electronics 29 is also protected with a camera damper 28. Overall, the whole microscope has an external acoustic cover 27 and anti-vibrational standing blocks 32. There is also an ion pump 34 with recovery baking elements 36 and a baking unit 35 for automatized vacuum recovery, e. g. after transport or vacuum break.

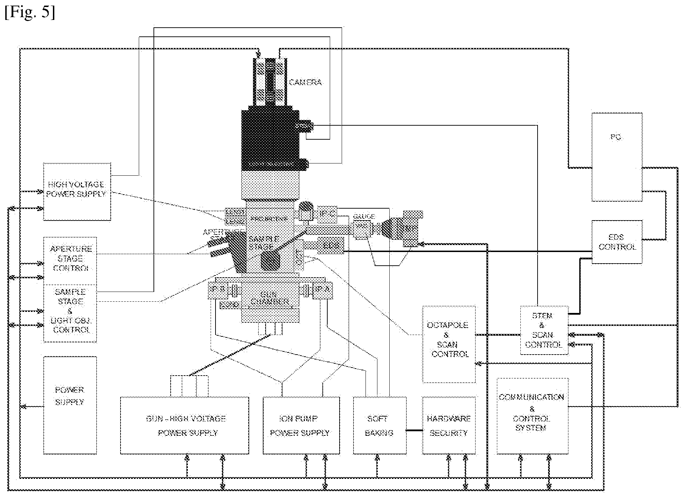

An example electron microscope together with associated electronics is schematically shown in Fig. 5. Only electronically-controlled components of the electron microscope are shown, i. e. without the permanent magnets, which are not electronically controlled. The electronically-controlled components include electronics-optics components, i. e. a gun chamber connected with conditioning (COND), two ion pumps (IP-A, IP-B) and a microscope chamber comprising a sample stage, an aperture stage, a projective, an octupole, two lenses and connected to gauge vacuum, an EDS detector, an ion pump (IP-C) and a turbomolecular pump (TMP). The electronically-controlled components also include light-optics components, i. e. a light objective, a STEM detector, a camera (a combined TEM/ED detector). The gun chamber is powered and controlled by a gun high voltage power supply unit. The ion pumps are powered and controlled by an ion pump power supply unit, and further controlled by a baking unit (denoted as "soft baking") for automatized vacuum recovery, further connected to a hardware security unit. The sample stage and the light objective is powered and controlled by a combined sample stage and light objective control unit. The aperture stage and is powered and controlled by an aperture stage control unit. The lenses are powered and controlled by a high voltage power supply unit. The octupole is powered and controlled by an octupole and scan control unit and a STEM and scan control unit. The EDS detector is powered and controlled by an EDS control unit, which in turn also controls the STEM and scan control unit. The STEM detector is powered a high voltage power supply unit and controlled by a STEM and scan control unit. All of the above mentioned units are further connected to a general power supply unit and a general communication and control system. The camera is also powered by a general power supply unit. The turbomolecular pump and the gauge vacuum are powered by a general power supply unit and controlled by a general communication and control system. The camera, the EDS control unit, the STEM and scan control unit and the general communication and control system are digitally connected to a computer.

### Industrial Applicability

The present invention can be used for obtaining detailed images and detailed analysis of many samples without the risk of sample damage. Typical application for this instrument is an analysis of samples from the borderline between life and material science, e. g. tissue sections with nanomaterials (for diagnostic, therapeutic or research purposes, as well as industrial or institutional inspection), where TEM mode provides the user with fast structural analysis, STEM provides deeper insight into the structural details, SEM offers the basic surface analysis, EDS information on chemical composition and ED the additional information on crystal structure.

### Reference Signs List

- 1: electron beam source
- 2: electrostatic condenser lens means
- 3: first magnetostatic condenser lens means
- 4: second magnetostatic condenser lens means
- 5: condenser aperture
- 6: sample holder
- 7: magnetostatic objective lens means
- 8: objective aperture
- 9: first electrostatic projective lens means
- 10: second electrostatic projective lens means
- 11: detection screen
- 12: primary electron beam
- 13: first objective polepiece
- 14: second objective polepiece
- 15: EDS detector
- 16: collimator
- 17: SEM detector
- 18: end detection system
- 19: light objective
- 20: light signal
- 21: tilting mirror
- 22: TEM/ED detector
- 23: STEM detector
- 24: magnetic shielding
- 25: cooling means damper
- 26: column damper
- 27: acoustic cover
- 28: camera damper
- 29: control electronics and high voltage supply
- 30: cables
- 31: cable clamping
- 32: anti-vibrational standing block
- 33: thermal shielding
- 34: ion pump
- 35: baking unit
- 36: recovery baking element
- 101: electron beam source
- 102: electromagnetic condenser lens means
- 106: sample holder
- 107: electromagnetic objective lens means
- 108: objective aperture
- 109: intermediate lens means
- 110: electromagnetic projective lens means
- 111: detection screen

## Claims

1. A multi-mode low-voltage electron microscope operative in the accelerating voltage range of 3-50 kV and comprising in the following order based on the direction of a primary electron beam (12):
an electron beam source (1) to generate the primary electron beam (12),
a first magnetostatic condenser lens means (3),
a second magnetostatic condenser lens means (4),
a condenser aperture (5),
a sample holder (6),
a magnetostatic objective lens means (7),
an objective aperture (8),
a first electrostatic projective lens means (9), and
an end detection system (18) comprising a detection screen (11) and at least one detector selected from a STEM detector (23) configured to detect a signal of transmitted electrons, a TEM detector configured to detect a signal of transmitted electrons and/or an ED detector configured to detect a signal of diffracted electrons,
wherein the second magnetostatic condenser lens means (4) and the magnetostatic objective lens means (7) together comprise a first objective polepiece (13) and a second objective polepiece (14) with the sample holder (6) arranged therebetween,
**characterised in that** an EDS detector (15) configured to detect a signal of energy-dispersed X-ray radiation is arranged between the first objective polepiece (13) and the second objective polepiece (14), essentially co-planarly and laterally with respect to the sample holder (6), wherein the EDS detector (15) comprises a collimator (16) attached to the second objective polepiece (14).

2. The multi-mode low-voltage electron microscope according to claim 1, wherein a SEM detector (17) configured to detect a signal of back-scattered electrons is arranged between the first objective polepiece (13) and the sample holder (6).

3. The multi-mode low-voltage electron microscope according to claim 1 or 2, wherein the TEM detector and the ED detector are constructed as a combined TEM/ED detector (22) comprising a camera.

4. The multi-mode low-voltage electron microscope according to any of the preceding claims, wherein the STEM detector (23) comprises a photomultiplier tube.

5. The multi-mode low-voltage electron microscope according to any of the preceding claims, wherein the STEM detector (23) and/or the TEM detector (22) is/are configured to detect transmitted electrons in a bright field detection mode and in a dark field detection mode.

6. The multi-mode low-voltage electron microscope according to any of the preceding claims, wherein a tilting mirror (21) is arranged in the end detection system (18) between the detection screen (11) and the STEM, TEM and ED detectors (22, 23) such that the tilting mirror (21) allows a light signal (20) generated by the detection screen (11) to pass to the TEM and/or ED detector (22) in a first position and to the STEM detector (23) in a second position.

7. The multi-mode low-voltage electron microscope according to any of the preceding claims, wherein the position of the sample holder (6) is vertically adjustable.

8. The multi-mode low-voltage electron microscope according to any of the preceding claims, wherein it comprises an electrostatic condenser lens means (2) arranged between the electron beam source (1) and the first magnetostatic condenser lens means (3).

9. The multi-mode low-voltage electron microscope according to any of the preceding claims, wherein it comprises a second electrostatic projective lens means (10) arranged between the first electrostatic projective lens means (9) and the end detection system (18).

10. The multi-mode low-voltage electron microscope according to any of the preceding claims, wherein the end detection system (18) comprises a light objective (19) arranged between the detection screen (11) and at least one detector (22, 23), or between the detection screen (11) and the tilting mirror (21).

11. The multi-mode low-voltage electron microscope according to any of the preceding claims, wherein it further comprises integrated control electronics and high voltage supply (29) and a cooling means, wherein the remaining part of the electron microscope is electromagnetically shielded from the control electronics and high voltage supply (29) and the cooling means by means of magnetic shielding (24) and/or thermally shielded from the control electronics and high voltage supply (29) and the cooling means by means of thermal shielding (33) and/or vibrationally shielded from the control electronics and high voltage supply (29) and the cooling means by means of a cooling means damper (25) and/or a column damper (26) and/or a camera damper (28).

12. The multi-mode low-voltage electron microscope according to any of the preceding claims, wherein it is at least partially shielded by means of an X-ray shield.

13. The multi-mode low-voltage electron microscope according to any of the preceding claims, wherein it comprises an ion pump (34) configured to create vacuum and integrally coupled with at least one recovery baking element (36), wherein the recovery baking element (36) is connected to a baking unit (35).

## Patentansprüche

1. Ein multimodales Niederspannungs-Elektronenmikroskop, das im Beschleunigungsspannungsbereich von 3 bis 50 kV wirksam ist und das in der folgenden Reihenfolge basiert auf der Richtung eines Primärelektronenstrahls (12) umfasst:
eine Elektronenstrahlquelle (1) zum Erzeugen des primären Elektronenstrahls (12),
ein erstes magnetostatisches Kondensatorlinsenmittel (3),
ein zweites magnetostatisches Kondensatorlinsenmittel (4),
eine Kondensatoröffnung (5),
einen Probenhalter (6),
ein magnetostatisches Objektivlinsenmittel (7),
eine Objektivöffnung (8),
ein erstes elektrostatisches Projektivlinsenmittel (9), und
ein Enddetektionssystem (18), das einen Detektionsbildschirm (11) und mindestens einen Detektor umfasst, wobei der Detektor aus einem STEM-Detektor (23), der eingerichtet ist, um ein Signal von übertragenen Elektronen zu erfassen, einem TEM-Detektor, der eingerichtet ist, um ein Signal von übertragenen Elektronen zu erfassen und/oder einem ED-Detektor, der eingerichtet ist, um ein Signal von gebeugten Elektronen zu erfassen, ausgewählt ist,
wobei das zweite magnetostatische Kondensatorlinsenmittel (4) und das magnetostatische Objektivlinsenmittel (7) zusammen ein erstes Objektivpolstück (13) und ein zweites Objektivpolstück (14) umfassen, mit dem dazwischen angeordneten Probenhalter (6),
**dadurch gekennzeichnet, dass** zwischen dem ersten Objektivpolstück (13) und dem zweiten Objektivpolstück (14), ein EDS-Detektor (15) angeordnet ist, der dazu eingerichtet ist, um ein Signal energiedisperser Röntgenstrahlung zu erfassen, und im Wesentlichen ko-planar und seitlich zum Probenhalter (6) angeordnet ist, wobei der EDS-Detektor (15) einen Kollimator (16) umfasst, der an dem zweiten Objektivpolstück (14) befestigt ist.

2. Das multimodale Niederspannungs-Elektronenmikroskop nach Anspruch 1, wobei zwischen dem ersten Objektivpolstück (13) und dem Probenhalter (6), ein SEM-Detektor (17) angeordnet ist, der eingerichtet ist, um ein Signal von rückgestreuten Elektronen zu erfassen.

3. Das multimodale Niederspannungs-Elektronenmikroskop nach Anspruch 1 oder 2, wobei der TEM-Detektor und der ED-Detektor als kombinierter TEM/ED-Detektor (22) ausgebildet sind, der eine Kamera umfasst.

4. Das multimodale Niederspannungs-Elektronenmikroskop nach einem der vorhergehenden Ansprüche, wobei der STEM-Detektor (23) eine Photovervielfacherröhre umfasst.

5. Das multimodale Niederspannungs-Elektronenmikroskop nach einem der vorhergehenden Ansprüche, wobei der STEM-Detektor (23) und/oder der TEM-Detektor (22) eingerichtet sind, um übertragene Elektronen in einem Hellfeld-Detektionsmodus und in einem Dunkelfeld-Detektionsmodus zu erfassen.

6. Das multimodale Niederspannungs-Elektronenmikroskop nach einem der vorhergehenden Ansprüche, wobei ein Kippspiegel (21) in dem Enddetektionssystem (18) zwischen dem Detektionsschirm (11) und den STEM-, TEM-und ED-Detektoren (22, 23) angeordnet ist, so dass der Kippspiegel (21) ein Lichtsignal (20) ermöglicht, das durch den Detektionsbildschirm (11) erzeugt wird, um zu dem TEM-und/oder ED-Detektor (22) in einer ersten Position und zu dem STEM-Detektor (23) in einer zweiten Position zu gelangen.

7. Das multimodale Niederspannungs-Elektronenmikroskop nach einem der vorhergehenden Ansprüche, wobei die Position des Probenhalters (6) vertikal einstellbar ist.

8. Das multimodale Niederspannungs-Elektronenmikroskop nach einem der vorhergehenden Ansprüche, wobei es ein elektrostatisches Kondensatorlinsenmittel (2) umfasst, das zwischen der Elektronenstrahlquelle (1) und dem ersten magnetostatischen Kondensatorlinsenmittel (3) angeordnet ist.

9. Das multimodale Niederspannungs-Elektronenmikroskop nach einem der vorhergehenden Ansprüche, wobei es ein zweites elektrostatisches Projektivlinsenmittel (10) umfasst, das zwischen dem ersten elektrostatischen projektiven Linsenmittel (9) und dem Enddetektionssystem (18) angeordnet ist.

10. Das multimodale Niederspannungs-Elektronenmikroskop nach einem der vorhergehenden Ansprüche, wobei das Enddetektionssystem (18) ein Lichtobjektiv (19) umfasst, das zwischen dem Detektionsbildschirm (11) und mindestens einem Detektor (22, 23) oder zwischen dem Detektionsbildschirm (11) und dem Kippspiegel (21) angeordnet ist.

11. Das multimodale Niederspannungs-Elektronenmikroskop nach einem der vorhergehenden Ansprüche, wobei es ferner eine integrierte Steuerelektronik und Hochspannungsversorgung (29) und ein Kühlmittel umfasst, wobei der restliche Teil des Elektronenmikroskops von der Steuerelektronik und Hochspannungsversorgung (29) und dem Kühlmittel mittels einer magnetischen Abschirmung (24) elektromagnetisch abgeschirmt ist und/oder von der Steuerelektronik und Hochspannungsversorgung (29) und dem Kühlmittel mittels einer Wärmeabschirmung (33) thermisch abgeschirmt ist und/oder von der Steuerelektronik und Hochspannungsversorgung (29) und dem Kühlmittel mittels eines Kühlmitteldämpfers (25) und/oder eines Säulendämpfers (26) und/oder eines Kameradämpfers (28) vibrierend abgeschirmt ist.

12. Das multimodale Niederspannungs-Elektronenmikroskop nach einem der vorhergehenden Ansprüche, wobei es zumindest teilweise mittels einer Röntgenabschirmung abgeschirmt ist.

13. Das multimodale Niederspannungs-Elektronenmikroskop nach einem der vorhergehenden Ansprüche, wobei es eine lonenpumpe (34) umfasst, die eingerichtet ist, um Vakuum zu erzeugen und die einstückig mit mindestens einem Rückgewinnungs-Backelement (36) gekoppelt ist, wobei das Rückgewinnungs-Backelement (36) mit einer Backeinheit (35) verbunden ist.

## Revendications

1. Un microscope électronique basse tension multimode, fonctionnant dans la plage de tension d'accélération de 3 à 50 kV et comprenant dans l'ordre suivant sur la base de la direction d'un faisceau d'électrons primaires (12) :
une source de faisceau d'électrons (1) pour générer le faisceau d'électrons primaires (12),
un premier moyen de lentille de condenseur magnétostatique (3),
un second moyen de lentille de condenseur magnétostatique (4),
une ouverture de condenseur (5),
un porte-échantillon (6),
un moyen de lentille d'objectif magnétostatique (7),
une ouverture d'objectif (8),
un premier moyen de lentille projective électrostatique (9), et
un système de détection d'extrémité (18) comprenant un écran de détection (11) et au moins un détecteur choisi parmi un détecteur STEM (23) configuré pour détecter un signal d'électrons émis, un détecteur TEM configuré pour détecter un signal d'électrons émis et/ou un détecteur ED configuré pour détecter un signal d'électrons diffractés,
où le second moyen de lentille de condenseur magnétostatique (4) et le moyen de lentille d'objectif magnétostatique (7) comprennent ensemble une première pièce d'objectif (13) et une seconde pièce d'objectif (14) avec le support d'échantillon (6) disposé entre celles-ci,
**caractérisé en ce qu'**un détecteur EDS (15) configuré pour détecter un signal de rayonnement de rayons X dispersé en énergie est disposé entre la première pièce d'objectif (13) et la seconde pièce d'objectif (14), essentiellement de manière coplanaire et latérale par rapport au porte-échantillon (6), où le détecteur EDS (15) comprend un collimateur (16) fixé à la seconde pièce d'objectif (14).

2. Le microscope électronique basse tension multimode selon la revendication 1, dans lequel un détecteur SEM (17) configuré pour détecter un signal d'électrons rétrodiffusés est disposé entre la première pièce d'objectif (13) et le porte-échantillon (6).

3. Le microscope électronique basse tension multimode selon la revendication 1 ou 2, dans lequel le détecteur TEM et le détecteur ED sont construits sous la forme d'un détecteur TEM/ED combiné (22) comprenant une caméra.

4. Le microscope électronique basse tension multimode selon l'une quelconque des revendications précédentes, dans lequel le détecteur STEM (23) comprend un tube photomultiplicateur.

5. Le microscope électronique basse tension multimode selon l'une quelconque des revendications précédentes, dans lequel le détecteur STEM (23) et/ou le détecteur TEM (22) est/sont configuré(s) pour détecter des électrons transmis dans un mode de détection de champ lumineux et dans un mode de détection de champ sombre.

6. Le microscope électronique basse tension multimode selon l'une quelconque des revendications précédentes, dans lequel un miroir basculant (21) est disposé dans le système de détection d'extrémité (18) entre l'écran de détection (11) et les détecteurs STEM, TEM et ED (22, 23) de sorte que le miroir basculant (21) permet le passage d'un signal lumineux (20) généré par l'écran de détection (11) vers le détecteur TEM et/ou ED (22) dans une première position et vers le détecteur STEM (23) dans une seconde position.

7. Le microscope électronique basse tension multimode selon l'une quelconque des revendications précédentes, dans lequel la position du porte-échantillon (6) est réglable verticalement.

8. Le microscope électronique basse tension multimode selon l'une quelconque des revendications précédentes, dans lequel il comprend un moyen de lentille de condenseur électrostatique (2) disposé entre la source de faisceau d'électrons (1) et le premier moyen de lentille de condenseur magnétostatique (3).

9. Le microscope électronique basse tension multimode selon l'une quelconque des revendications précédentes, dans lequel il comprend un deuxième moyen de lentille projective électrostatique (10) disposé entre le premier moyen de lentille projective électrostatique (9) et le système de détection d'extrémité (18).

10. Le microscope électronique basse tension multimode selon l'une quelconque des revendications précédentes, dans lequel le système de détection d'extrémité (18) comprend un objectif lumineux (19) disposé entre l'écran de détection (11) et au moins un détecteur (22, 23), ou entre l'écran de détection (11) et le miroir basculant (21).

11. Le microscope électronique basse tension multimode selon l'une quelconque des revendications précédentes, comprenant en outre une électronique de commande intégrée et une alimentation haute tension (29) et un moyen de refroidissement, où la partie restante du microscope électronique est protégée électromagnétiquement de l'électronique de commande et de l'alimentation haute tension (29) et du moyen de refroidissement au moyen d'un blindage magnétique (24) et/ou protégée thermiquement de l'électronique de commande et de l'alimentation haute tension (29) et du moyen de refroidissement au moyen d'un blindage thermique (33) et/ou protégée par vibration de l'électronique de commande et de l'alimentation haute tension (29) et du moyen de refroidissement au moyen d'un amortisseur de moyen de refroidissement (25) et/ou d'un amortisseur de colonne (26) et/ou d'un amortisseur de caméra (28).

12. Le microscope électronique basse tension multimode selon l'une quelconque des revendications précédentes, dans lequel il est au moins partiellement protégé au moyen d'un blindage contre les rayons X.

13. Le microscope électronique basse tension multimode selon l'une quelconque des revendications précédentes, dans lequel il comprend une pompe ionique (34) configurée pour créer un vide et intégralement couplée à au moins un élément de cuisson à récupération (36), où l'élément de cuisson à récupération (36) est relié à une unité de cuisson (35).
